# EUROPEAN PATENT SPECIFICATION

(11) **EP 4 293 885 B1**
(45) Date of publication and mention of the grant of the patent: **17.06.2026**
(21) Application number: 22178579.3
(22) Date of filing: 13.06.2022
(51) Int. Cl.: H02K 11/26

(54) **DIODE CARRIER ARRANGEMENT, OVERVOLTAGE PROTECTION DEVICE WITH THE SAME, MOTOR VEHICLE COMPONENT WITH THE SAME AND MANUFACTURING METHOD FOR A DIODE CARRIER ARRANGEMENT**
DIODENTRÄGERANORDNUNG, ÜBERSPANNUNGSSCHUTZVORRICHTUNG MIT DERSELBEN, KRAFTFAHRZEUGBAUTEIL MIT DERSELBEN UND HERSTELLUNGSVERFAHREN FÜR EINE DIODENTRÄGERANORDNUNG
AGENCEMENT DE SUPPORT DE DIODE, DISPOSITIF DE PROTECTION CONTRE LES SURTENSIONS LE COMPRENANT, COMPOSANT DE VÉHICULE À MOTEUR LE COMPRENANT ET PROCÉDÉ DE FABRICATION DE SUPPORT DE DIODE

(43) Date of publication of application: 20.12.2023
(73) Proprietor: MAHLE International GmbH, 70376 Stuttgart (DE)
(72) Inventor: COTAR MLAKAR, Janko, 5294 Dornberk (SI)
(74) Representative: BRP Renaud & Partner mbB Rechtsanwälte Patentanwälte Steuerberater

(56) References cited:
- FR-A1- 2 978 885
- GB-A- 976 458
- US-A- 6 140 722
- US-A1- 2010 117 466

## Description

The invention relates to a diode carrier arrangement according to the preamble of Claim 1. The invention relates to an overvoltage protection with a diode carrier arrangement, further to a motor vehicle component with a diode carrier arrangement or to an overvoltage protection device and, further to a manufacturing method for a diode carrier arrangement.

A diode carrier arrangement of the type mentioned at the outset is described for example in document US 2010 / 117 466 A1.

Further diode carrier arrangements are described in the documents GB 976 458 A and US 3,876,926 A. These are usually installed as individual component in the engine compartment of a motor vehicle and cabled to an electric machine so that a corresponding installation space has to be reserved there for it and cabling. Disadvantageous in this is that because of this the installation space of the engine compartment that is already greatly limited anyway is reduced although as large as possible an available installation space is desired.

The object of the invention consists in providing an improved or at least another embodiment of a diode carrier arrangement. In particular an attempt is to be made to state an overvoltage protection device with a diode carrier arrangement and a motor vehicle component with a diode carrier arrangement or an overvoltage protection device. Furthermore, a manufacturing method for a diode carrier arrangement is to be provided.

With the present invention, this object is solved in particular through the subjects of the independent claims. Advantageous embodiments are subject of the dependent claims and of the description.

For solving the object, a diode carrier arrangement for an overvoltage protection device for an electric machine, in particular a generator, further in particular an alternator of a motor vehicle, is proposed. The diode carrier arrangement is suitable for being integrated in the electric machine. The diode carrier arrangement comprises at least two diodes, which are each equipped with a diode body, at least one electrical connection contact pin arranged thereon for electrically contacting a respective diode and an electrical connection contact formed by the diode body or formed integrally with the diode body for electrically contacting a respective diode, a rail arrangement comprising two separate electrically conductive metal rails, at least one separate electrically conductive metal plate, an enclosure arranged on the rail arrangement and the at least one metal plate for holding the rail arrangement and the at least one metal plate, for example a moulded-on plastic enclosure. Here, the enclosure holds the at least one metal plate sandwich-like between the metal rails so that the at least one metal plate does not directly touch the metal rails, i.e. is contactless with respect to these, and flanked by the metal rails on both sides. It is substantial that the diode carrier arrangement according to the invention comprises at least one first diode receptacle delimited or formed by way of the enclosure and a first metal rail of these two metal rails for receiving a diode and at least one second diode receptacle delimited or formed by way of the enclosure and the at least one metal plate for receiving a diode. A first diode is inserted into the at least one first diode receptacle, wherein the said first diode with its at least one connection contact pin is integrally connected to the at least one metal plate in an electrically conductive manner, in particular soldered or welded, and by way of the enclosure clamped onto the first metal rail so that its connection contact and/or its diode body is contacted with the first metal rail electrically and in a thermally conductive manner. A second diode is inserted into the at least one second diode receptacle, wherein the said second diode with its at least one connection contact pin is integrally connected to a second metal rail of these two metal rails in an electrically conductive manner, in particular soldered or welded, and by way of the enclosure clamped onto the at least one metal plate so that its connection contact and/or its diode body is electrically and thermally conductively contacted with the at least one metal plate. By way of this, a diode carrier arrangement carrying at least two (in particular identical) diodes is provided, which can be integrated for example in an electric machine, in particular a generator, further in particular an alternator of a motor vehicle, as a result of which advantageously an installation space usually necessary for installing a diode carrier arrangement within an engine compartment of a motor vehicle can be saved and otherwise allocated.

In order to improve the heat conduction between a diode body of at least one diode and the first metal rail and/or the at least one metal plate, it can be practically provided that between the diode body of the at least one diode and the first metal rail and/or the at least one metal plate, heat-conducting paste or heat-conducting adhesive is introduced, which wets both the diode body of the at least one diode as well as the first metal rail and/or the at least one metal plate.

The said diodes can be realised, for example, by transient voltage suppressor diodes (so called TVS diodes). To the person skilled in the art the transient voltage suppressor diode is a protection diode designed to protect electronic circuits against transients and overvoltage threats. In particular, it is designed to absorb large amounts of energy (e.g. joules) in a very short period of time (e.g. milliseconds).

Preferably it is provided that the at least one first diode receptacle and the at least one second diode receptacle are arranged on two sides of the diode carrier arrangement that are opposite to one another. Because of this, the first diode receptacles and second diode receptacles of the diode carrier arrangement can be relatively easily and briskly equipped with diodes since the diodes can be fed to the diode carrier arrangement from different sides. Furthermore, this results in a relatively compact design. Alternatively, the at least one first diode receptacle and the at least one second diode receptacle can be arranged on one same side of two sides of the diode carrier arrangement that are opposite to one another. This is advantageous, if additional ribbed heat sinks arranged on the first metal rail and/or the second metal rail. This can be important for heat dissipation purposes.

Further preferably it is provided that the at least one first diode receptacle and the at least one second diode receptacle are equal in size. Because of this, identical diodes, i.e. diodes of identical size, can be inserted into the respective diode receptacles. Because of this, the installation of the diode carrier arrangement is possible without major effort since the diodes need not be assigned to specific diode receptacles but instead can be inserted into any diode receptacles.

Preferably it is provided that the at least one first diode receptacle is arranged in a first plane or at least two first diode receptacles define a first plane. Furthermore, the at least one second diode receptacle can be arranged in a second plane or at least two second diode receptacles define a second plane. Further, the first plane and the second plane can be arranged parallel and/or offset to one another. Because of this, an advantageous embodiment is stated, by way of which the metal rails and the metal plates of the diode carrier arrangement can be relatively easily connected to one another in an electrically conductive and/or thermally conductive manner.

Further preferably it is provided that the first metal rail and/or the second metal rail and/or the at least one metal plate are each realised integrally and/or through a flat body each. Furthermore, the first diode arranged in the at least one first diode receptacle can be electrically connected in series with the second diode arranged in the at least one second diode receptacle. Here, it can be preferably provided that the first diode arranged in the at least one first diode receptacle is electrically connected in series with the second diode arranged in the at least one second diode receptacle and, with respect to at least one further first diode and at least one further second diode, which are arranged in a further first diode receptacle and a further second diode receptacle respectively and are electrically connected in series with one another, are electrically connected in parallel. Because of this, the metal rails and/or the metal plates can be cost-effectively provided in large quantities, so that the diode carrier arrangement altogether can be realised cost-effectively.

Preferably it is provided that the enclosure is formed by a one-piece contiguous component or by separate segments. Because of this, the enclosure of the diode carrier arrangement can be realised cost-effectively and in particular as an injection-moulded part.

Further preferably it is provided that the first metal rail in its main extension defines a main axis and is zoned into three contiguous flat rail portions extending in the direction of the main axis. Here, the first metal rail can comprise two integral bending portions, which are each arranged with respect to the main axis between two rail portions and integrally connect these to one another, wherein the bending portions are deformed or bent for example as part of the installation of the diode carrier arrangement on an electric machine, in particular a generator, further in particular an alternator of a motor vehicle transversely to the main axis, so that the rail portions are tilted to one another by a predetermined or predeterminable bending angle. It is practical when the bending angle amounts to maximally 45° and/or the bending angle amounts to minimally 5° or is smaller than 5°. Here it can be also provided in particular that a width of the bending portions, which is oriented transversely with respect to the main axis, is smaller than a width of the rail portions that are likewise oriented transversely with respect to the main axis. In this connection it can also be provided that a width of the bending portions, which are oriented transversely with respect to the main axis, amounts to maximally 50% or particularly less than 25% or more particularly less than 10% of a width of the rail portions likewise oriented transversely with respect to the main axis, and/or that a width of the bending portions which are oriented transversely with respect to the main axis, amounts to at least 25% of a width of the rail portions likewise oriented transversely with respect to the main axis. Because of this, the first metal rail can be deformed or bent with simple means, for example manually by hand, in particular transversely to its main direction, wherein merely the said bending portions plastically deform permanently while the said rail portions remain flat. Initially, this has the advantage that the diode carrier arrangement or the first metal rail as part of its installation can be adapted relatively easily to curved or complex contours of an electric machine, in particular a generator, further in particular an alternator of a motor vehicle. Furthermore, this has the advantage that the rail portions reserved for the arrangement of the diodes are flat and thus remain easily equippable with diodes. Optionally, the bending portions could be divided each in two separate bending subportions which are easier to bend. Particularly, in that case the width of each bending subportion would be less than 25% of the width of the rail portions.

The term "zoning" is also understood as "subdividing" by the person skilled in the art.

Preferably it is provided that the at least one first diode receptacle is delimited or formed by a flat rail portion of the first metal rail and by a first transverse support element of the enclosure. Here, the first transverse support element can elastically clamp the first diode inserted into the at least one first diode receptacle onto the respective rail portion of the first metal rail. Further it can be provided that the at least one second diode receptacle is delimited or formed by the at least one metal plate and by a second transverse support element of the enclosure, wherein, practically, the second transverse support element elastically clamps the second diode inserted into the at least one second diode receptacle onto the at least one metal plate. By way of this, preferred embodiments for diode receptacles are stated. It is practical when the said first and second transverse support elements of the enclosure are each embodied bar-shaped and/or have a rectangular cross-section. It is practical, furthermore, when the enclosure besides the transverse support elements has so-called support elements which are directly arranged on the said metal rails and the at least one metal plate, are orthogonally oriented with respect to the transverse support elements and are embodied integrally with the same.

Further preferably it is provided that the rail arrangement comprises a connection contact tab arranged on the first metal rail of these two metal rails, which is equipped for soldering on or welding on, in particular by resistance welding or laser welding, of a power supply conductor of an electric machine. In particular, the said connection contact tab may can be curved and/or cranked or realise an offset connection contact tab. Further it can be provided that the rail arrangement comprises a further, in particular offset, connection contact tab arranged on the second metal rail of these two metal rails, which is equipped for soldering on or welding on a neutral conductor of an electric machine, in particular by resistance welding. Practically, the connection contact tab and the further connection contact tab are arranged on two sides of the diode carrier arrangement that are opposite to one another. Because of this, the diode carrier arrangement has practical electrical connecting tabs by way of which its diodes can be supplied with electric energy. Practically, the connecting tab and the further connecting tab can be arranged on a common side of the diode carrier arrangement, as a result of which the electrical installation of these on an electric machine is simplified since the connecting tab and the further connecting tab are reachable from a side by an installer. Preferably, the connecting tab and/or the further connecting tab can be formed integrally with the first metal rail or with the second metal rail.

Preferably it is provided that the enclosure comprises fastening projections for fastening the diode carrier to an electric machine, in particular a generator, further in particular an alternator of a motor vehicle. Further, the fastening projections can each be equipped with a central opening for fastening means, in particular a fastening screw. By way of this, the diode carrier arrangement can be fastened to an electric machine with simple means, for example with fastening screws.

Further preferably it is provided that the enclosure is produced from a thermoplastic material, for example from an injection-mouldable polyamide 66 (PA66), from polybutylene terephthalate (PBT), polyethylene terephthalate (PET) or from a similar injection-mouldable plastic material. Instead it can be provided that the enclosure is produced from a thermoplastic material, for example from an injection-mouldable polyamide 66 (PA66), from polybutylene terephthalate (PBT), polyethylene terephthalate (PET) or from a similar injection-mouldable plastic as well as a filling material, in particular a glass or mineral fibre filling material. Because of this, the enclosure of the diode carrier arrangement can be realised cost-effectively and in particular as an injection-moulded part since the defined plastic materials all exhibit a relatively favourable suitability for injection moulding.

Preferably, a filling material can be admixed to the plastic material used in order to mechanically reinforce the enclosure.

Preferably it is provided that the first metal rail and/or the second metal rail are realised by punched parts and/or are punched out of a thin conductive metal sheet. Furthermore, it can be provided that the first metal rail and/or the second metal rail are realised from copper material, brass material, bronze material or other conductive metal materials. Furthermore, the at least one metal plate can be realised through a punched part and/or be punched out of a thin conductive metal sheet. It can also be provided that the at least one metal plate is realised from copper material, brass material, bronze material or other conductive metal materials. Because of this, the metal rails and/or the metal plates can be provided cost-effectively and in large quantities so that the diode carrier arrangement can be realised altogether cost-effectively. By copper material, the invention means for example pure copper or copper alloys, in particular brass material or bronze material. Such metal rails and/or metal plates additionally have the major advantage that they have a relatively good electrical conductivity and at the same time also a good thermal conductivity. Because of this, the diodes can be outstandingly connected for example to an electrical supply network of a generator or of an alternator. Furthermore, heat energy incurred on the diodes during the operation of the diode carrier arrangement can be efficiently discharged.

Another basic idea of the invention, which can be realised additionally or alternatively to the basic idea mentioned further up can consist in providing an overvoltage protection device for an electric machine, in particular a generator, further in particular an alternator of a motor vehicle, which comprises at least one diode carrier arrangement according to the preceding description. Here, the diodes of the diode carrier arrangement can be configured to or practically equipped in order to protect the electric machine from a supply voltage also referred to as overvoltage, which, because of a fault increases above the rated voltage of the electric machine. By way of this, an advantageous overvoltage protection device for an electric machine is provided. The overvoltage protection device can be space-savingly arranged for example within the electric machine and there electrically contacted with the electric machine.

Another basic idea of the invention, which can be realised additionally or alternatively to the basic idea mentioned further up can consist in providing a motor vehicle component, in particular an electric machine, in particular a generator, further in particular an alternator of a motor vehicle which comprises at least one diode carrier arrangement arranged within the motor vehicle component and electrically contacted with the same according to the preceding description or comprises at least one overvoltage protection device arranged within the motor vehicle component and electrically contacted with the same for an electric machine according to the preceding description. The said motor vehicle component can optionally comprise a main body and a protective cover that can be placed or is placed on the same, which on a cover inside comprises a clamping device which is equipped for receiving and clamping the diode carrier arrangement or the overvoltage protection device. Preferably, the clamping device comprises clamping projections forming or delimiting a clamping receptacle which can be embodied for example integrally with the protective cover. In the assembled state of the motor vehicle component, the diode carrier arrangement or the overvoltage protection device is inserted into the clamping receptacle, wherein the clamping projections clamp and/or snap into the enclosure of the diode carrier arrangement or the overvoltage protection device, as a result of which the diode carrier arrangement or the overvoltage protection device is fixed on the protective cover. Because of this, in particular own movements of the diode carrier arrangement or of the overvoltage protection device as a consequence of vibrations occurring on the protective cover can be prevented, which for example contributes to the noise reduction. Altogether, an advantageous motor vehicle component, in particular an electric machine, with a diode carrier arrangement or an overvoltage protection device is thereby stated, wherein through the arrangement of the diode carrier arrangement or of the overvoltage protection device within the motor vehicle component for example an installation space usually necessary for installing a diode carrier arrangement or the overvoltage protection device within an engine compartment of a motor vehicle can be saved and otherwise allocated.

Furthermore, a motor vehicle component, in particular an electric machine, further in particular a generator, further in particular an alternator of a motor vehicle, can be provided, the motor vehicle component comprising a diode carrier arrangement, for example according to the above description, wherein the diode carrier arrangement is assembled with a protective cover of the motor vehicle component to form a subassembly, wherein the diode carrier arrangement is pressed against the protective cover and fixed to the protective cover by clamping, for example by fastening projections of the diode carrier arrangement or by friction with pressing into slits and the power supply and the ground supply connectors of the protective cover are soldered or welded to the power and ground connectors of the diode carrier arrangement. For example, the subassembly can be formed only after the diode carrier arrangement is inserted-pressed against the protective cover and also the connectors are welded or soldered. This way the diode carrier arrangement can be on one side fixed and secured with plastic projections and welded conductors and on the other side it can become fixed only after being screwed to the main body of the motor vehicle together with the protective cover. The protective cover further comprising a cover power supply conductor connector configured for serving as a power supply for the diode carrier arrangement and a cover neutral conductor connector configured for serving as a ground supply for the diode carrier arrangement, wherein the said subassembly is assembled to a main body of the motor vehicle component by fastening means, preferably screws, wherein the fastening means, preferably the screws, go through the fastening projections of the diode carrier arrangement and fastening projections of protective cover. Thereby a preferred embodiment is provided.

Another basic idea of the invention, which can be realised additionally or alternatively to the basic idea mentioned further up can consist in stating a manufacturing method for a diode carrier arrangement. To this end, the following steps are:
1) providing a punched blank, which comprises a first metal rail, a second metal rail and between the first metal rail and the second metal rail at least one metal plate, wherein the at least one metal plate is realised by way of installation aid ribs is integrally connected to the first metal rail and integrally connected to the second metal rail of a metallic plate material, which is optionally realised by copper material, brass material, bronze material or other conductive metal materials by punching out, and
2) adapting the two metal rails (4, 18) to a predetermined contour of an electric machine (46) by deforming or bending, and
3) providing an enclosure for holding the two metal rails and the at least one metal plate of a thermoplastic material, for example of an injection-mouldable polyamide 66 (PA66), from polybutylene terephthalate (PBT), polyethylene terephthalate (PET) or from a similar injection-mouldable plastic material, and/or a filling material, in particular a glass or mineral fibre filling material, and providing at least one first diode receptacle for receiving a diode and at least one second diode receptacle for receiving a diode, in that the provided punched blank, subject to forming or delimiting the at least one first diode receptacle and the at least one second diode receptacle, is over-moulded, for example by means of an injection moulding machine, and
4) severing or cutting off of the installation aid ribs (74) by punching, and
5) inserting a first diode into the at least one first diode receptacle, so that this first diode is clamped onto the metal rail by way of the enclosure so that the first metal rail, in particular its connection contact and/or its diode body, is electrically as well as thermally conductively contacted with the first metal rail, and electrically conductive integral connecting of the at least one connection contact pin of this first diode with the at least one metal plate, in particular soldering-on or welding-on, and
6) inserting a second diode into the at least one second diode receptacle, so that this second diode is clamped onto the at least one metal plate by way of the enclosure, so that the said metal plate, in particular its connection contact and/or its diode body is electrically and thermally conductively contacted with the at least one metal plate, and electrically conductive integral connecting of the at least one connection contact pin of this second diode with a second metal rail of these two metal rails, in particular soldering-on or welding-on.

By way of this, a preferred manufacturing method for a diode carrier arrangement is stated, by way of which a diode carrier arrangement can be provided for example cost-effectively.

In summary it remains to note: the present invention preferentially relates to a diode carrier arrangement comprising diodes, a rail arrangement comprising metal rails, at least one metal plate and an enclosure for holding the rail arrangement and/or the at least one metal plate. It is substantial that by way of the enclosure and a first metal rail of these metal rails a first diode receptacle for receiving diodes and by way of the enclosure and the at least one metal plate, a second diode receptacle for receiving diodes is delimited. In the diode receptacle, diodes are inserted and by way of the enclosure clamped onto the first metal rail or the at least one metal plate. The invention relates in particular to an overvoltage protection device with a diode carrier arrangement, further in particular to a motor vehicle component with a diode carrier arrangement or to an overvoltage protection device and further in particular to a manufacturing method for a diode carrier arrangement.

Further important features and advantages of the invention are obtained from the dependent claims, from the drawings and from the associated figure description by way of the drawings.

It is to be understood that the features mentioned above and still to be explained in the following cannot only be used in the respective combination stated but also in other combinations or by themselves without leaving the scope of the present invention.

Preferred embodiments of the invention are shown in the drawings and are explained in more detail in the following description, wherein same reference numbers relate to same or similar or functionally same components.

It shows, in each case schematically
- Fig. 1: a perspective view of a diode carrier arrangement according to a preferred embodiment,
- Fig. 2: the diode carrier arrangement from Fig. 1 in a perspective view looking in the direction of an arrow II entered in Fig. 1,
- Fig. 3: the diode carrier arrangement from Fig. 1 in a plan view looking in the direction of an arrow III entered in Fig. 1,
- Fig. 4: in a greatly simplified sectional view the diode carrier arrangement from Fig.1 cut open along a plane indicated in Fig. 1 with dashed line looking in the direction of an arrow IV entered there,
- Fig. 5: in a perspective view a punched blank for producing a diode carrier arrangement 1 according to Fig. 1 to 4 approximately looking in the direction of an arrow V entered in Fig. 1,
- Fig. 6: a perspective view of a motor vehicle component realised by an electric machine with a diode carrier arrangement according to Fig. 1 to 5 and finally,
- Fig. 7: a perspective view of the motor vehicle component from Fig. 6, wherein a protective cover of the motor vehicle component is lifted off and turned upside down so that a cover inside of the protective cover and a diode carrier arrangement arranged there is noticeable.

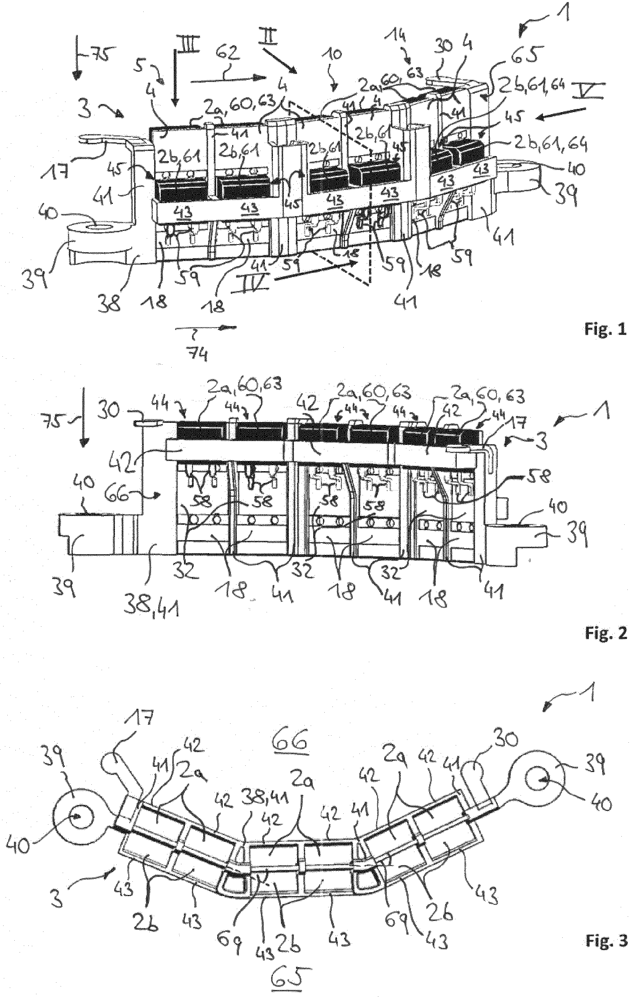

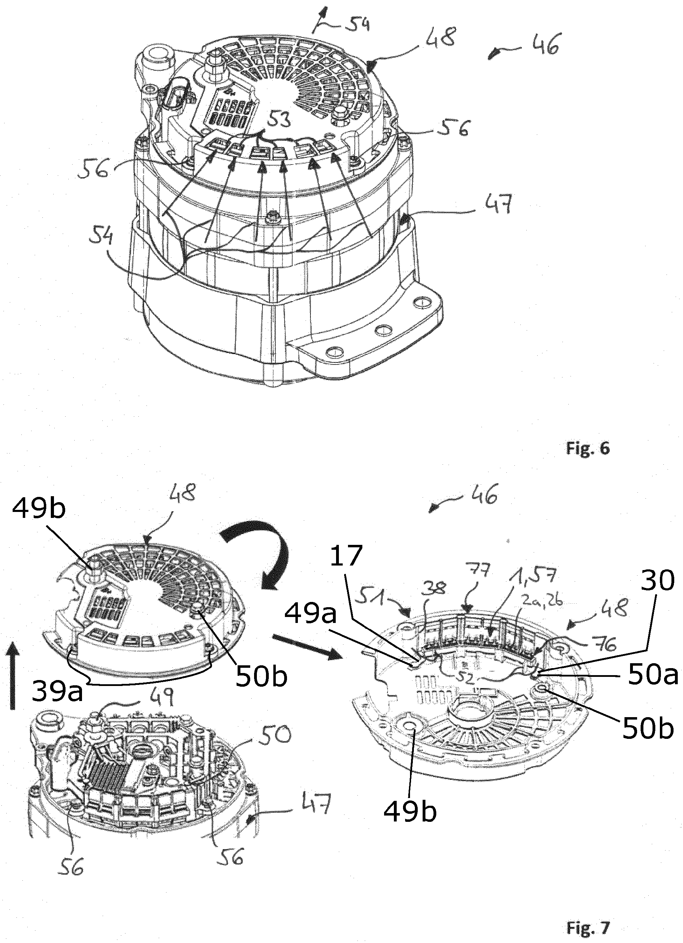

Fig. 1 to 4 show a preferred exemplary embodiment of a diode carrier arrangement designated altogether with the reference number 1 for a motor vehicle component 46 illustrated in Fig. 6 and 7 realised exemplarily by an electric machine 46, which alternatively could also be realised by a generator and further in particular by an alternator of a motor vehicle.

Fig. 1 and 2 each show the diode carrier arrangement 1 in a perspective view, namely looking from the front (Fig. 1) or from the back (Fig. 2). The diode carrier arrangement 1 comprises multiple, altogether twelve diodes 2a, 2b of the same size and shape, which are each equipped with a diode body 60, 61, each with two electrical connection contact pins 58, 59 arranged on the respective diode body 60, 61 for electrically contacting a respective diode 2a, 2b and each with an electrical connection contact 63, 64 formed by the respective diode body 60, 61 or integrally formed with the respective diode body 60, 61 for electrically contacting a respective diode 2a, 2b. For example, the diodes 2a, 2b are realised by commercially available transient voltage suppressor diodes, so called TVS diodes.

Furthermore, the diode carrier arrangement 1 comprises a rail arrangement 3, the exemplarily two separate electrically conductive metal rails 4, 18, namely a first metal rail 4 and a second metal rail 18, as well as an offset connection contact tab 17 arranged integrally on the first metal rail 4 and configured for soldering-on or welding-on a power supply conductor 49 of a motor vehicle component 46 or a cover power supply conductor connector 49a of a protective cover 48 of the motor vehicle component 46 or an electric machine 46 and an offset further connection contact tab 30 arranged integrally on the second metal rail 18 and configured for soldering-on or welding-on a neutral conductor 50 of a motor vehicle component 46 or a cover neutral conductor connector 50a of the protective cover 48 of the motor vehicle component 46 or of an electric machine 46. The connection contact tabs 17, 30 are exemplarily arranged on sides of the diode carrier arrangement 1 that are opposite to one another. The first metal rail 4 and the second metal rail 18 are each embodied flat, for example each formed by a flat body, and for example realised as punched parts, which with the help of a punching tool are punched out of a rolled or coiled plate material of copper material, brass material, bronze material or another conductive metal material. The first metal rail 4 defines in its main extension a main axis 62, the second metal rail 18 defines in its main extension a further main axis 74. The first metal rail 4 and the second metal rail 18 are arranged in parallel with respect to the main axes 62, 74 and are spaced apart from one another transversely with respect to their main axes 62, 74, so that the first metal rail 4 and the second metal rail 18 do not directly touch and as a result of which between them a receptacle for metal plates 32 explained in the following is delimited. Preferably, the main axes 62, 74 respectively the first metal rail 4 and the second metal rail 18 can be bent.

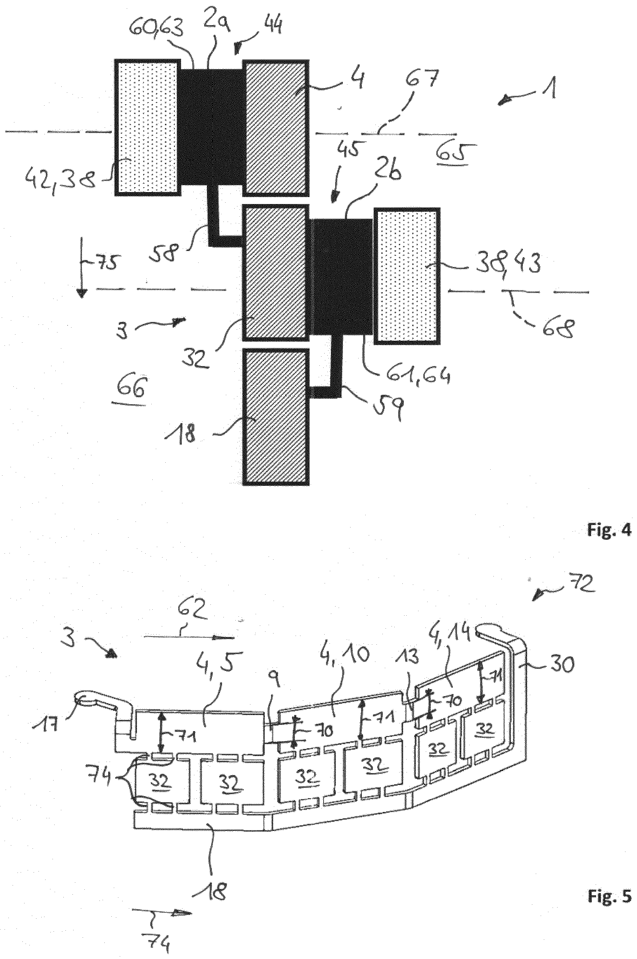

The first metal rail 4 is zoned, i.e. subdivided, into three contiguous flat rail portions 5, 10, 14 arranged one behind the other in the direction of the main axis 62 extending in the direction of the main axis 62, see in particular Fig. 1 and 5. To achieve better cylindrical shape or curved shape of the diode carrier arrangement 1, the first metal rail 4 is, for example, subdivided into six flat rail portions ideally - one for each diode 2a. With this design the first metal rail 4 is simplified and some bending is saved. Also the insertion of the diodes 2a and the welding of the diodes 2a, i.e. their respective diode bodies 60, 61, on that flat rail portions is simplified. Depending on needs and available space, the first metal rail 4 could also be subdivided in more or less flat portions. The first metal rail 4, further, comprises two integral bending portions 9. 13, see Fig. 5, which are each connected with respect to the main axis 62, between the rail portions 5, 10, 14 and integrally connect the same with one another. The bending portions 9, 13 are or can be deformed or bent as part of the installation of the diode carrier arrangement 1 on a motor vehicle component 46 or an electric machine 46 transversely to the main axis 62, as a result of which the rail portions 5, 10, 14 are tilted to one another by a predetermined or predeterminable bending angle 69, so that the first metal rail 4 altogether has a bent contour. Preferably, the second metal rail 18 is also deformed or bent according to the first metal rail 4 so that it also has a bent contour. Because of this, the first and second metal rail 4, 18 can be relatively easily and flexibly adapted as part of their installation on a motor vehicle component 46 or an electric machine 46 to curved or complex contours of the motor vehicle component 46 or the electric machine 46. It is practical in this connection when a width 70 of the bending portions 9, 13, see Fig. 5, which are oriented transversely, in particular perpendicularly with respect to the main axis, 62, is smaller than a width 71 of the rail portions 5, 10, 14 likewise oriented transversely, in particular perpendicularly with respect to the main axis 62. By way of this it can be ensured that when adapting the first metal rail 4 to a contour of the motor vehicle component 46 or the electric machine 46, only the bending portions 9, 13 deform or bent while the rail portions 5, 10, 14 remain in their flat original form, so that the diodes 2a, 2b explained at the outset can be easily placed onto them with optimal electrical and thermal conductivity.

In addition, the diode carrier arrangement 1 comprises altogether six separate electrically conductive metal plates 32. These have purely exemplarily a rectangular or square outer contour each and are each embodied flat and for example realised as punched parts, which are punched out of a rolled or coiled plate material of copper material, brass material, bronze material or another conductive metal material with the help of a punching tool. The metal plates 32 are arranged in the said receptacle between the first metal rail 4 and the second metal rail 18 so that they do not directly touch the first metal rail 4 and the second metal rail 18 and are flanked by the metal rails 4, 18 on both sides, see in particular Fig. 4.

Besides the rail arrangement 3 and the metal plates 32, the diode carrier arrangement 1 comprises a monolithic enclosure 38 arranged on the rail arrangement 3, i.e. on the first metal rail 4, the second metal rail 18 and practically on the connection contact tabs 17, 30 and/or the said metal plates 32, which is equipped to hold the rail arrangement 3 and/or the said metal plates 32 and/or the diodes 2a, 2b. According to the present embodiment, the enclosure 38 is realised through a plastic enclosure 38 moulded onto the rail arrangement 3 and/or the said metal plates 32, which can be produced for example from a thermoplastic material, for example of an injection-mouldable polyamide 66 (PA66), from polybutylene terephthalate (PBT), polyethylene terephthalate (PET), or from a similar injection-mouldable plastic material, as well as optionally a filling material for stiffening, in particular a glass or mineral fibre filling material in order to realise a cost-effective manufacture of the enclosure 38 with relatively good strength and stiffness characteristics at the same time. In particular in Fig. 1 to 3 it is noticeable that the enclosure 38, with respect to the main axes 62, 74, comprises support elements 41 arranged at a right angle and first and second transverse support elements 42, 43 which with respect to the main axes 62, 74 are arranged in parallel and fastening projections 39 arranged on two sides of the diode carrier arrangement 1 located opposite one another, for example in the neighbourhood of the connection contact tabs 17, 30 for fastening the diode carrier arrangement 1 to a motor vehicle component 46 or to an electric machine 46. As mentioned, the support elements 41, the first and second transverse support elements 42, 43 and the fastening projections 39 form a monolithic enclosure 38. Nevertheless, the enclosure 38 could also be embodied in segments. It should be mentioned, furthermore, that the said fastening projections 39 are each formed by a ring projection with a central opening 40 for fastening means, in particular a fastening screw 56. However, other fastening means or fastening measures are also conceivable by means of which the diode carrier arrangement 1 can be fastened to a motor vehicle component 46 or to an electric machine 46, for example snap-in connections, clamping connections or bonded connections are conceivable. With respect to Fig. 1 and 2 it should be noted that the enclosure 38 optionally also holds the said metal plates 32, so that it is arranged, sandwich-like and contact-free between the metal rails 4, 18 as mentioned.

It is substantial that the diode carrier arrangement 1 comprises at least one first diode receptacle 44 delimited or formed by way of the enclosure 38 and of the first metal rail 4 for receiving diodes 2a, 2b and at least one second diode receptacle 45 delimited or formed by way of the enclosure 38 and of the at least one metal plate 32 for receiving diodes 2a, 2b. According to the present embodiment, six first diode receptacles 44 arranged in series in the direction of the main axis 62 are exemplarily provided for first diodes 2a. Here, the first diode receptacles 44 are each delimited by a flat rail portion 5, 10, 14 of the first metal rail 4 and by a first transverse support element 42 of the enclosure 38. In each first diode receptacle 44, a first diode 2a is inserted with its connection contact pins 58 upfront in an extension direction 75, in the manner that a respective first transverse support element 42 clamps a respective inserted first diode 2a, i.e. its connection contact 63 and/or its diode body 60 elastically onto the respective rail portion 5, 10, 14 of the first metal rail 4, wherein the connection contact pins 58 of a respective first diode 2a are arranged on a metal plate 32 of these six metal plates 32. Because of this, the respective connection contact 63 and/or the diode body 60 of a first diode 2a are electrically and thermally conductively contacted with the first metal rail 4. In order to optimise the electrical and/or thermal contacting of the first diodes 2a with the first metal rail 4, heat conducting paste or heat conducting adhesive can be practically connected in between. The said connection contact pins 58 of the first diodes 2a can be or are integrally connected to the said metal plates 32 in an electrically conductive manner in particular by soldering or welding, in particular resistance welding. Furthermore, six second diode receptacles 45 for second diodes 2b arranged in series in the direction of the main axis 62 are provided according to the present embodiment. Here, the second diode receptacles 45 are each delimited by a flat metal plate 32 and by a second transverse support element 43 of the enclosure 38. In each second diode receptacle 45, a second diode 2b is inserted with its connection contact pins 59 upfront in the extension direction 75, in the manner that a respective second transverse support element 43 elastically clamps a respective inserted second diode 2b, i.e. its connection contact 64 and/or its diode body 61, onto the respective metal plate 32, wherein the connection contact pins 59 of a respective second diode 2b are arranged on the second metal rail 18. Because of this, the connection contact 64 and/or the diode body 61 of a respective second diode 2b is electrically and thermally conductively contacted with a respective metal plate 32. In order to optimise the electrical and/or thermal contacting of the second diodes 2b with the respective metal plate 32, heat-conducting paste or heat-conducting adhesive can be practically connected in between. The said connection contact pins 59 of the second diodes 2b can or are integrally connected to the second metal rail 18 in an electrically conductive manner for example by soldering or welding, in particular resistance welding. By way of this configuration, the first metal rail 4 and the second metal rail 18 are electrically conductively connected to one another via at least one first diode 2a, at least one metal plate 32 and at least one second diode 2b. By way of this it is provided, further, that a first diode 2a is assigned to a second diode 2b or vice versa, as a result of which an electrical series connection of these diodes 2a, 2b is realised in a branch. Adjacent branches, i.e. the diodes 2a, 2b of adjacent diode receptacles 44, 45 electrically connected in series are practically arranged electrically connected in parallel to one another. In Fig. 1 and 2 it is noticeable, furthermore, that the first diode receptacles 44 and the second diode receptacles 45 are arranged on two sides 65, 66 of the diode carrier arrangement 1 that are opposite to one another and identical in size. Because of this, identical diodes 2a, 2b, i.e. diodes of the same size can be inserted into the respective diode receptacles 44, 45, wherein the installation is relatively simple since the diodes 2a, 2b can be fed to the diode carrier arrangement 1 from different sides 65, 66 and in a common insertion direction 75. Furthermore, it is noticeable for example in Fig. 4 that the first diode receptacles 44 are arranged in a first plane 67 indicated by a dashed line or define the same and that the second diode receptacles 45 are arranged in a further second plane 68 indicated by a dashed line or define the same, wherein the first plane 67 and the second plane 68 are parallel and offset to one another.

Fig. 5 shows in a perspective view a punched blank 72 which can be utilised in the production of a diode carrier arrangement 1 from Fig. 1 to 4. The punched blank 72 forms an integral unit and includes the first metal rail 4, the second metal rail 18 and, between the first metal rail 4 and the second metal rail 18, the explained six metal plates 32. The latter are, in the state of the punched blank 72 as delivered, initially integrally connected to the first metal rail 4 and to the second metal rail 18 by way of installation aid ribs 74, which in Fig. 5 are provided with reference number for only one metal plate 32. Because of this, the handling of the punched blank 72 is relatively simple and handy, since metal rails 4, 18 and metal plates 32 form a unit. The punched blank 72 is realised for example with the help of a punching tool from a metallic plate material which is optionally a copper material, brass material, bronze material or other conductive metal material. As soon as the punched blank 72 has been stabilised by injection moulding-on the enclosure 38, the installation aid ribs 74 can be severed, for example by punching.

Fig. 6 and 7 show a preferred exemplarily embodiment of a motor vehicle component marked as a whole with the reference number 46, which is realised by an electric machine 46 here. It comprises at least one diode carrier arrangement 1 according to Fig. 1 to 4 arranged within the motor vehicle component 46 and electrically contacted with the same. In this case, the diode carrier arrangement 1 is provided as overvoltage protection device 57, wherein its first and second diodes 2a, 2b are equipped in order to protect the electric machine 46 from a supply voltage also referred to as overvoltage, which, because of an internal or external fault, rises above the rated voltage of the electric machine 46. The motor vehicle component 46 exemplarily comprises a main body 47 and a protective cover 48, preferably a cover member, that can be placed or is placed onto the same and can be releasably fixed to the main body 47 by way of fastening screws 56. The protective cover 48 has on a cover inside 77 a clamping device 51 which is equipped for receiving and clamping the diode carrier arrangement 1 or the overvoltage protection device 57 on the protective cover 48. Practically, the clamping device 51 comprises clamping projections 52 forming or delimiting a clamping receptacle 76, which are embodied for example integrally with the protective cover 48. In the assembled state of the motor vehicle component 46, the diode carrier arrangement 1 or the overvoltage protection device 57 is inserted into the clamping receptacle 76, wherein the clamping projections 52 of the clamping device 51 clamp and/or snap into the enclosure 38 of the diode carrier arrangement 1 or the overvoltage protection device 57, as a result of which the diode carrier arrangement 1 or the overvoltage protection device 57 is fixed to the protective cover 48. Because of this, in particular own movements of the diode carrier arrangement 1 or of the overvoltage protection device 57 as a consequence of vibrations occurring on the protective cover 48 can be prevented, which contributes for example to the reduction of noise. As mentioned above, the main body 47 comprises a power supply conductor 49 and a neutral conductor 50 which are electrically contacted with the first connection contact tab 17 respectively the further connection contact tab 30 of the diode carrier arrangement 1 or of the overvoltage protection device 57, when the protective cover 48 equipped with the diode carrier arrangement 1 or the overvoltage protection device 57 is installed on the main body 47. It is provided that the protective cover 48 comprising a cover power supply conductor connector 49a configured for serving as a cover side power connector supply for the connection contact tab 17 of the diode carrier arrangement 1 and a cover neutral conductor connector 50a configured for serving as a cover side ground connector supply for the connection contact tab 30 of the diode carrier arrangement 1. Besides the aforementioned cover power supply conductor connector 49a and cover neutral conductor connector 50a the protective cover 48 further comprising two main connection connectors 49b, 50b for electrically connecting with the power supply conductor 49 respectively the neutral conductor 50 of said main body 47. It must also be mentioned, that the cover power supply conductor connector 49a is electrically conductive connected via a not shown cover connector line to the first main connection connector 49b and the cover neutral conductor connector 50a is, in the same way, electrically conductive connected to the second main connection connector 50b. For instance, the cover power supply conductor connector 49a, the cover neutral conductor connector 50a, the first main connection connector 49b and the second main connection connector 50b are integrally overmoulded into the protective cover 48 to form an uniform unit. Preferably, the protective cover 48 is therefore made of a plastic material, for example an injection moldable plastic material. In the assembled state, the diode carrier arrangement 1 is assembled, for example clamped, with the protective cover 48 in such a way that the connection contact tab 17 of the diode carrier arrangement 1 is in electrically contact with the cover power supply conductor connector 49a and the connection contact tab 30 of the diode carrier arrangement 1 is in electrically contact with the cover neutral conductor connector 50a.

Preferably, the said connection tabs 17, 30 are each welded to the cover power supply conductor 49a respectively to the cover neutral conductor 50a. The protective cover 48 is assembled to the main body 47 of the motor vehicle component by fastening means, preferably fastening screws. Preferably the fastening screws go through the fastening projections 39 of the diode carrier arrangement 1 and fastening projections 39a of the protective cover 48.

The protective cover 48, furthermore, has ventilation openings designated with reference number 53, see in particular Fig. 6, by way of which a cooling airstream 54 of cooling air indicated by arrows there flows into the motor vehicle component 46 and cools the diode carrier arrangement 1 or the overvoltage protection device 57.

## Claims

1. A diode carrier arrangement (1) for an overvoltage protection device for an electric machine (46),
- the diode carrier arrangement (1) being suitable for being integrated in the electric machine (46),
- the diode carrier arrangement (1) comprising:
- at least two diodes (2a, 2b), which are each equipped with a diode body (60, 61) and with at least one electrical connection contact pin (58, 59) arranged thereon for electrically contacting a respective diode (2a, 2b) and an electrical connection contact (63, 64) formed by the diode body (60, 61) or integrally formed with the diode body (60, 61) for electrically contacting a respective diode (2a, 2b),
- a rail arrangement (3) comprising two separate electrically conductive metal rails (4, 18),
- at least one separate electrically conductive metal plate (32),
wherein
- the diode carrier arrangement (1) is further comprising an enclosure (38) arranged on the rail arrangement (3) and the at least one metal plate (32) for holding the rail arrangement (3) and the at least one metal plate (32),
- wherein the enclosure (38) holds the at least one metal plate (32) sandwich-like between the metal rails (4, 18) so that the at least one metal plate (32) does not directly touch the metal rails (4, 18) and is flanked by the metal rails (4, 18),
- wherein the diode carrier arrangement (1) comprises at least one first diode receptacle (44) delimited or formed by way of the enclosure (38) and a first metal rail (4) of the two metal rails (4, 18) for receiving a diode (2a, 2b) and at least one second diode receptacle (45) delimited or formed by way of the enclosure (38) and the at least one metal plate (32) for receiving a diode (2a, 2b),
- wherein a first diode (2a) is inserted into the at least one first diode receptacle (44) and is integrally connected with its at least one connection contact pin (58) to the at least one metal plate (32) in an electrically conductive manner and by way of the enclosure (38) is clamped onto the first metal rail (4) so that its connection contact (63) is contacted to the first metal rail (4) electrically and thermally conductively,
- wherein a second diode (2b) is inserted into the at least one second diode receptacle (45), with its at least one connection contact pin (59) integrally connected in an electrically conductive manner to a second metal rail (18) of the two metal rails (4, 18) and by way of the enclosure (38) is clamped onto the at least one metal plate (32) so that its connection contact (64) and/or its diode body (61) is electrically contacted with the at least one metal plate (32) in a thermally conductive manner.

2. The diode carrier arrangement (1) according to Claim 1,
**characterised in that**
- the at least one first diode receptacle (44) and the at least one second diode receptacle (45) are arranged on two sides (65, 66) of the diode carrier arrangement (1) that are opposite to one another, or
- the at least one first diode receptacle (44) and the at least one second diode receptacle (45) are arranged on one same side (65, 66) of two sides (65, 66) of the diode carrier arrangement (1) that are opposite to one another.

3. The diode carrier arrangement (1) according to Claim 1 or 2,
**characterised in that**
the at least one first diode receptacle (44) and the at least one second diode receptacle (45) are identical in size.

4. The diode carrier arrangement (1) according to any one of the preceding claims,
**characterised in that**
- the at least one first diode receptacle (44) is arranged in a first plane (67) or at least two first diode receptacles (44) define a first plane (67), and/or
- the at least one second diode receptacle (45) is arranged in a second plane (68) or at least two second diode receptacles (45) define a second plane (68), and/or
- the first plane (67) and the second plane (68) are parallel to one another and/or offset to one another.

5. The diode carrier arrangement (1) according to any one of the preceding claims,
**characterised in that**
- the first metal rail (4) and/or the second metal rail (18) and/or the at least one metal plate (32) are each realised integrally and/or by a flat body each, and/or
- the first diode (2a) arranged in the at least one first diode receptacle (44) are electrically connected in series with the second diode (2b) arranged in the at least one second diode receptacle (45), and/or
- the first diode (2a) arranged in the at least one first diode receptacle (44) are electrically connected in series with the second diode (2b) arranged in the at least one second diode receptacle (45) and with respect to at least one further first diode (2a) and at least one further second diode (2b), which are arranged in a further first diode receptacle (44) or a further second diode receptacle (45) and are electrically connected in series with one another, are electrically connected in parallel.

6. The diode carrier arrangement (1) according to any one of the preceding claims,
**characterised in that**
the enclosure (38) is formed by a one-piece contiguous component or by separate segments.

7. The diode carrier arrangement (1) according to any one of the preceding claims,
**characterised in that**
- the first metal rail (4) in its main extension defines a main axis (62) and is zoned into three contiguous flat rail portions (5, 10, 14) extending in the direction of the main axis (62),
- wherein the first metal rail (4) comprises two integral bending portions (9, 13), which with respect to the main axis (62) are each arranged between two rail portions (5, 10, 14) and integrally connect the same with one another,
- wherein the bending portions (9, 13) are deformed or bent transversely to the main axis (62) so that the rail portions (5, 10, 14) are tilted towards one another by a predetermined or predeterminable bending angle (69), and/or
- wherein the bending angle (69) maximally amounts to 45° and/or
- wherein the bending angle (69) minimally amounts to 5° or smaller than 5°,
- wherein a width (70) of the bending portions (9, 13) which are oriented transversely with respect to the main axis (62), is smaller than a width (71) of the rail portions (5, 10, 14) likewise oriented transversely with respect to the main axis (62), or
- wherein a width (70) of the bending portions (9, 13) which are oriented transversely with respect to the main axis (62) amounts to maximally 50% or particularly less than 25% or more particularly less than 10% of a width (71) of the rail portions (5, 10, 14) likewise oriented transversely with respect to the main axis (62), and/or
- wherein a width (70) of the bending portions (9, 13), which are oriented transversely with respect to the main axis (62), amounts to at least 25% of a width (71) of the rail portions (5, 10, 14) likewise oriented transversely with respect to the main axis (62).

8. The diode carrier arrangement (1) according to Claim 7,
**characterised in that**
- the at least one first diode receptacle (44) is delimited or formed by a flat rail portion (5, 10, 14) of the first metal rail (4) and by a first transverse support element (42) of the enclosure (38), and/or
- wherein the first transverse support element (42) elastically clamps the first diode (2a) inserted into the at least one first diode receptacle (44) onto the respective rail portion (5, 10, 14) of the first metal rail (4), and/or
- the at least one second diode receptacle (45) is delimited or formed by the at least one metal plate (32) and by a second transverse support element (43) of the enclosure (38), and/or
- wherein the second transverse support element (43) elastically clamps the second diode (2b) inserted into the at least one second diode receptacle (45) onto the at least one metal plate (32).

9. The diode carrier arrangement (1) according to any one of the preceding claims,
**characterised in that**
- the rail arrangement (3) comprises an in particular offset connection contact tab (17) arranged on the first metal rail (4) of these two metal rails (4, 18), which is equipped for soldering on or welding on in particular by resistance welding, a power supply conductor (49) of an electric machine (46), and/or
- the rail arrangement (3) comprises a further in particular offset connection contact tab (30) arranged on the second metal rail (18) of these two metal rails (4, 18) which is equipped for soldering on or welding on, in particular by resistance welding, a neutral conductor (50) of an electric machine (46),
- the connection contact tab (17) and the further connection contact tab (30) is arranged on two sides of the diode carrier arrangement (1) that are opposite to one another.

10. The diode carrier arrangement (1) according to any one of the preceding claims,
**characterised in that**
- the enclosure (38) comprises fastening projections (39) for fastening the diode carrier arrangement (1) to an electric machine (46), in particular a generator, further in particular an alternator of a motor vehicle, and/or
- wherein the fastening projections (39) are each equipped with a central opening (40) for fastening means, in particular a fastening screw.

11. The diode carrier arrangement (1) according to any one of the preceding claims,
**characterised in that**
- the enclosure (38) is produced from a thermoplastic material, for example from an injection-mouldable polyamide 66 (PA66), from polybutylene terephthalate (PBT), polyethylene terephthalate (PET) or from a similar injection-mouldable plastic material and/or
- the enclosure (38) is produced from a thermoplastic material, for example from an injection-mouldable polyamide 66 (PA66), from polybutylene terephthalate (PBT), polyethylene terephthalate (PET) or from a similar injection-mouldable plastic material, and a filling material, in particular a glass or mineral fibre filling material.

12. The diode carrier arrangement (1) according to any one of the preceding claims,
**characterised in that**
- the first metal rail (4) and/or the second metal rail (18) are realised by way of punched parts and/or are punched out of a thin conductive metal sheet and/or
- the first metal rail (4) and/or the second metal rail (18) is realised from copper material, brass material, bronze material or other conductive metal materials, and/or
- the at least one metal plate (32) is realised by a punched part and/or punched out of a thin conductive metal sheet and/or
- the at least one metal plate (32) is realised from copper material, brass material, bronze material or other conductive metal materials.

13. An overvoltage protection device (57) for an electric machine (46),
in particular a generator, further in particular an alternator of a motor vehicle, comprising at least one diode carrier arrangement (1) according to the preceding Claims 1 to 12,
- wherein the diodes (2a, 2b) of the diode carrier arrangement (1) are configured for protecting the electrical machine (46) from a supply voltage also referred to as overvoltage, which because of a fault rises above a rated voltage of the electric machine (46).

14. A motor vehicle component, in particular an electric machine (46),
in particular a generator, further in particular an alternator of a motor vehicle, comprising
at least one overvoltage protection device (57) according to Claim 13 for an electric machine (46) arranged within the motor vehicle component and electrically contacted with the same, or
at least one diode carrier arrangement (1) according to the Claims 1 to 12 arranged within the motor vehicle component, in particular an electric machine (46),
wherein the diode carrier arrangement (1) is assembled with a protective cover (48) of the motor vehicle component to form a subassembly,
wherein the diode carrier arrangement (1) is pressed against the protective cover (48) and fixed to the protective cover (48) by clamping, for example by fastening projections (39) of the diode carrier arrangement (1),
wherein the protective cover (48) further comprising a cover power supply conductor connector (49a) configured for serving as a power supply for the diode carrier arrangement (1) and a cover neutral conductor connector (50a) configured for serving as a ground supply for the diode carrier arrangement (1),
wherein the said subassembly is assembled to a main body (47) of the motor vehicle component by fastening means, preferably fastening screws,
wherein the fastening means, preferably the fastening screws, go through the fastening projections (39) of the diode carrier arrangement (1) and fastening projections (39a) of the protective cover (48).

15. A manufacturing method for a diode carrier arrangement (1) according to the preceding claims with the steps:
1) providing a punched blank (72) comprises a first metal rail (4), a second metal rail (18) and between the first metal rail (4) and the second metal rail (18) at least one metal plate (32), wherein the at least one metal plate (32) is integrally connected to the first metal rail (4) by way of installation aid ribs (74) and is integrally connected to the second metal rail (18), of a metallic plate material by punching out, and
2) adapting the metal rails (4, 18) to a predetermined contour of an electric machine (46) by deforming or bending, and
3) providing an enclosure (38) for holding the metal rails (4, 18) and the at least one metal plate (32) of a thermoplastic material, for example of an injection-mouldable polyamide 66 (PA66), from polybutylene terephthalate (PBT), polyethylene terephthalate (PET) or from a similar injection-mouldable plastic material, and/or a filling material, in particular a glass or mineral fibre filling material, and providing at least one first diode receptacle (44) for receiving a diode (2) and at least one second diode receptacle (45) for receiving a diode (2), in that the provided punched blank (72), forming or delimiting the at least one first diode receptacle (44) and the at least one second diode receptacle (45), is over-moulded, and
4) severing or cutting off of the installation aid ribs (74) by punching, and
5) inserting a first diode (2a) into the at least one first diode receptacle (44), so that this first diode (2a) is clamped onto the first metal rail (4) by way of the enclosure (38), so that it is electrically and thermally conductively contacted with the first metal rail (4), and electrically conductive integral connecting of the at least one connection contact pin (58) of this first diode (2a) with the at least one metal plate (32), and
6) inserting a second diode (2b) into the at least one second diode receptacle (45), so that this second diode (2b) is clamped by way of the enclosure (38) onto the at least one metal plate (32) so that it is electrically and thermally conductively contacted with the at least one metal plate (32), and electrically conductive integral connecting of the at least one connection contact pin (59) of this second diode (2b) with a second metal rail (18) of these two metal rails (4, 18).

## Patentansprüche

1. Diodenträgeranordnung (1) für eine Überspannungsschutzvorrichtung für eine elektrische Maschine (46),
- wobei die Diodenträgeranordnung (1) geeignet ist, in die elektrische Maschine (46) integriert zu werden,
- wobei die Diodenträgeranordnung (1) umfasst:
- mindestens zwei Dioden (2a, 2b), die jeweils mit einem Diodenkörper (60, 61) und mit mindestens einem darauf angeordneten elektrischen Verbindungskontaktstift (58, 59) zum elektrischen Kontaktieren einer jeweiligen Diode (2a, 2b) und einem elektrischen Verbindungskontakt (63, 64), der durch den Diodenkörper (60, 61) gebildet wird oder integral mit dem Diodenkörper (60, 61) gebildet ist, ausgestattet sind, zum elektrischen Kontaktieren einer jeweiligen Diode (2a, 2b) ausgestattet sind,
- eine Schienenanordnung (3), die zwei getrennte elektrisch leitfähige Metallschienen (4, 18) umfasst,
- mindestens eine separate elektrisch leitfähige Metallplatte (32), wobei
- die Diodenträgeranordnung (1) weiter ein Gehäuse (38) umfasst, das auf der Schienenanordnung (3) und der mindestens einen Metallplatte (32) angeordnet ist, zum Halten der Schienenanordnung (3) und der mindestens einen Metallplatte (32),
- wobei das Gehäuse (38) die mindestens eine Metallplatte (32) sandwichartig zwischen den Metallschienen (4, 18) hält, sodass die mindestens eine Metallplatte (32) die Metallschienen (4, 18) nicht direkt berührt und von den Metallschienen (4, 18) flankiert wird,
- wobei die Diodenträgeranordnung (1) mindestens eine erste Diodenaufnahme (44) umfasst, die durch das Gehäuse (38) und eine erste Metallschiene (4) der beiden Metallschienen (4, 18) begrenzt oder gebildet ist, zur Aufnahme einer Diode (2a, 2b), und mindestens eine zweite Diodenaufnahme (45), die durch das Gehäuse (38) und die mindestens eine Metallplatte (32) begrenzt oder gebildet ist, zur Aufnahme einer Diode (2a, 2b),
- wobei eine erste Diode (2a) in die mindestens eine erste Diodenaufnahme (44) eingesetzt und mit ihrem mindestens einen Verbindungskontaktstift (58) elektrisch leitend mit der mindestens einen Metallplatte (32) integral verbunden ist und mittels des Gehäuses (38) an die erste Metallschiene (4) geklemmt ist, sodass ihr Verbindungskontakt (63) elektrisch und thermisch leitend mit der ersten Metallschiene (4) in Kontakt steht
- wobei eine zweite Diode (2b) in die mindestens eine zweite Diodenaufnahme (45) eingesetzt ist, mit ihrem mindestens einen Verbindungskontaktstift (59) elektrisch leitend mit einer zweiten Metallschiene (18) der beiden Metallschienen (4, 18) integral verbunden ist und mittels des Gehäuses (38) an die mindestens eine Metallplatte (32) geklemmt ist, sodass ihr Verbindungskontakt (64) und/oder ihr Diodenkörper (61) thermisch leitend elektrisch mit der mindestens einen Metallplatte (32) verbunden ist.

2. Diodenträgeranordnung (1) nach Anspruch 1,
**dadurch gekennzeichnet, dass**
- die mindestens eine erste Diodenaufnahme (44) und die mindestens eine zweite Diodenaufnahme (45) auf zwei einander gegenüberliegenden Seiten (65, 66) der Diodenträgeranordnung (1) angeordnet sind, oder
- die mindestens eine erste Diodenaufnahme (44) und die mindestens eine zweite Diodenaufnahme (45) auf eine gleichen Seite (65, 66) von zwei einander gegenüberliegenden Seiten (65, 66) der Diodenträgeranordnung (1) angeordnet sind.

3. Diodenträgeranordnung (1) nach Anspruch 1 oder 2,
**dadurch gekennzeichnet, dass**
die mindestens eine erste Diodenaufnahme (44) und die mindestens eine zweite Diodenaufnahme (45) gleich groß sind.

4. Diodenträgeranordnung (1) nach einem der vorstehenden Ansprüche,
**dadurch gekennzeichnet, dass**
- mindestens eine erste Diodenaufnahme (44) in einer ersten Ebene (67) angeordnet ist oder mindestens zwei erste Diodenaufnahmen (44) eine erste Ebene (67) definieren und/oder
- die mindestens eine zweite Diodenaufnahme (45) in einer zweiten Ebene (68) angeordnet ist oder mindestens zwei zweite Diodenaufnahmen (45) eine zweite Ebene (68) definieren, und/oder
- die erste Ebene (67) und die zweite Ebene (68) parallel zueinander sind und/oder zueinander versetzt sind.

5. Diodenträgeranordnung (1) nach einem der vorstehenden Ansprüche,
**dadurch gekennzeichnet, dass**
- die erste Metallschiene (4) und/oder die zweite Metallschiene (18) und/oder die mindestens eine Metallplatte (32) jeweils integral und/oder jeweils durch einen flachen Körper gefertigt ist, und/oder
- die erste Diode (2a), die in der mindestens einen ersten Diodenaufnahme (44) angeordnet ist, in Reihe mit der zweiten Diode (2b), die in der mindestens einen zweiten Diodenaufnahme (45) angeordnet ist, elektrisch verbunden ist, und/oder
- die erste Diode (2a), die in der mindestens einen ersten Diodenaufnahme (44) angeordnet ist, in Reihe mit der zweiten Diode (2b), die in der mindestens einen zweiten Diodenaufnahme (45) angeordnet ist, elektrisch verbunden ist, und in Bezug auf mindestens eine weitere erste Diode (2a) und mindestens eine weitere zweite Diode (2b), die in einer weiteren ersten Diodenaufnahme (44) oder einer weiteren zweiten Diodenaufnahme (45) angeordnet und miteinander elektrisch in Reihe verbunden sind, elektrisch parallel verbunden sind.

6. Diodenträgeranordnung (1) nach einem der vorstehenden Ansprüche,
**dadurch gekennzeichnet, dass**
das Gehäuse (38) durch eine einteilige, zusammenhängende Komponente oder durch separate Segmente gebildet ist.

7. Diodenträgeranordnung (1) nach einem der vorstehenden Ansprüche,
**dadurch gekennzeichnet, dass**
- die erste Metallschiene (4) in ihrer Haupterstreckung eine Hauptachse (62) definiert und in drei zusammenhängende flache Schienenabschnitte (5, 10, 14) aufgeteilt ist, die sich in Richtung der Hauptachse (62) erstrecken,
- wobei die erste Metallschiene (4) zwei integrale Biegeabschnitte (9, 13) umfasst, die in Bezug auf die Hauptachse (62) jeweils zwischen zwei Schienenabschnitten (5, 10, 14) angeordnet sind und dieselben integral miteinander verbinden,
- wobei die Biegeabschnitte (9, 13) quer zur Hauptachse (62) verformt oder gebogen sind, sodass die Schienenabschnitte (5, 10, 14) um einen vorbestimmten oder vorbestimmbaren Biegewinkel (69) zueinander geneigt sind, und/oder
- wobei der Biegewinkel (69) maximal 45° beträgt, und/oder
- wobei der Biegewinkel (69) mindestens 5° oder weniger als 5° beträgt,
- wobei eine Breite (70) der Biegeabschnitte (9, 13), die quer in Bezug zur Hauptachse (62) ausgerichtet sind, kleiner ist als die Breite (71) der Schienenabschnitte (5, 10, 14), die ebenfalls quer zur Hauptachse (62) ausgerichtet sind, oder
- wobei eine Breite (70) der Biegeabschnitte (9, 13), die quer in Bezug zur Hauptachse (62) ausgerichtet sind, höchstens 50% oder besonders weniger als 25% oder ganz besonders weniger als 10% einer Breite (71) der Schienenabschnitte (5, 10, 14) beträgt, die ebenfalls quer zur Hauptachse (62) ausgerichtet ist, und/oder
- wobei eine Breite (70) der Biegeabschnitte (9, 13), die quer in Bezug zur Hauptachse (62) ausgerichtet sind, mindestens 25% einer Breite (71) der Schienenabschnitte (5, 10, 14) beträgt, die ebenfalls quer zur Hauptachse (62) ausgerichtet sind.

8. Diodenträgeranordnung (1) nach Anspruch 7,
**dadurch gekennzeichnet, dass**
- die mindestens eine erste Diodenaufnahme (44) durch einen flachen Schienenabschnitt (5, 10, 14) der ersten Metallschiene (4) und durch ein erstes quer verlaufendes Stützelement (42) des Gehäuses (38) begrenzt oder gebildet wird, und/oder
- wobei das erste quer verlaufende Stützelement (42) die erste Diode (2a), die in die mindestens eine erste Diodenaufnahme (44) eingesetzt ist, elastisch an den jeweiligen Schienenabschnitt (5, 10, 14) der ersten Metallschiene (4) klemmt, und/oder
- die mindestens eine zweite Diodenaufnahme (45) durch die mindestens eine Metallplatte (32) und durch ein zweites quer verlaufendes Stützelement (43) des Gehäuses (38) begrenzt oder gebildet wird, und/oder
- wobei das zweite quer verlaufende Stützelement (43) die zweite Diode (2b), die in die mindestens eine zweite Diodenaufnahme (45) eingesetzt ist, elastisch an die mindestens eine Metallplatte (32) klemmt.

9. Diodenträgeranordnung (1) nach einem der vorstehenden Ansprüche,
**dadurch gekennzeichnet, dass**
- die Schienenanordnung (3) einen insbesondere versetzten Verbindungskontakt (17) umfasst, der auf der ersten Metallschiene (4) dieser beiden Metallschienen (4, 18) angeordnet ist, der zum Anlöten oder Anschweißen, insbesondere durch Widerstandsschweißen, eines Stromzuführungsleiters (49) einer elektrischen Maschine (46) ausgerüstet ist, und/oder
- die Schienenanordnung (3) einen weiteren insbesondere versetzten Verbindungskontakt (30) umfasst, der auf der zweiten Metallschiene (18) dieser beiden Metallschienen (4, 18) angeordnet ist, der zum Anlöten oder Anschweißen, insbesondere durch Widerstandsschweißen, eines Neutralleiters (50) einer elektrischen Maschine (46) ausgerüstet ist,
- der Verbindungskontakt (17) und der weitere Verbindungskontakt (30) auf zwei einander gegenüberliegenden Seiten der Diodenträgeranordnung (1) angeordnet sind.

10. Diodenträgeranordnung (1) nach einem der vorstehenden Ansprüche,
**dadurch gekennzeichnet, dass**
- das Gehäuse (38) Befestigungsvorsprünge (39) zum Befestigen der Diodenträgeranordnung (1) an einer elektrischen Maschine (46), insbesondere einem Generator, weiter insbesondere einer Lichtmaschine eines Kraftfahrzeugs umfasst, und/oder
- wobei die Befestigungsvorsprünge (39) jeweils mit einer zentralen Öffnung (40) für Befestigungsmittel, insbesondere eine Befestigungsschraube, ausgerüstet sind.

11. Diodenträgeranordnung (1) nach einem der vorstehenden Ansprüche,
**dadurch gekennzeichnet, dass**
- das Gehäuse (38) aus einem thermoplastischen Werkstoff, beispielsweise aus einem spritzgießfähigen Polyamid 66 (PA66), aus Polybutylenterephthalat (PBT), Polyethylenterephthalat (PET) oder aus einem ähnlichen spritzgießfähigen Kunststoff hergestellt wird und/oder
- das Gehäuse (38) aus einem thermoplastischen Werkstoff, beispielsweise aus einem spritzgießfähigen Polyamid 66 (PA66), aus Polybutylenterephthalat (PBT), Polyethylenterephthalat (PET) oder aus einem ähnlichen spritzgießfähigen Kunststoff, und einem Füllmaterial, insbesondere einem Glas- oder Mineralfaserfüllmaterial, hergestellt wird.

12. Diodenträgeranordnung (1) nach einem der vorstehenden Ansprüche,
**dadurch gekennzeichnet, dass**
- die erste Metallschiene (4) und/oder die zweite Metallschiene (18) mittels Stanzteilen realisiert werden und/oder aus einem dünnen leitfähigen Metallblech ausgestanzt werden und/oder
- die erste Metallschiene (4) und/oder die zweite Metallschiene (18) aus Kupfermaterial, Messingmaterial, Bronzematerial oder anderen leitfähigen Metallmaterialien realisiert ist und/oder
- die mindestens eine Metallplatte (32) durch ein Stanzteil hergestellt wird und/oder aus einem dünnen leitfähigen Metallblech ausgestanzt wird und/oder
- die mindestens eine Metallplatte (32) ist aus Kupfermaterial, Messingmaterial, Bronzematerial oder anderen leitfähigen Metallmaterialien realisiert ist.

13. Überspannungsschutzvorrichtung (57) für eine elektrische Maschine (46), insbesondere einen Generator, weiter insbesondere eine Lichtmaschine eines Kraftfahrzeugs, umfassend mindestens eine Diodenträgeranordnung (1) nach den vorstehenden Ansprüchen 1 bis 12,
- wobei die Dioden (2a, 2b) der Diodenträgeranordnung (1) zum Schützen der elektrischen Maschine (46) vor einer Zuführspannung, die auch als Überspannung bezeichnet wird, konfiguriert sind, die aufgrund eines Fehlers über eine Nennspannung der elektrischen Maschine (46) ansteigt.

14. Kraftfahrzeugkomponente, insbesondere eine elektrische Maschine (46), insbesondere ein Generator, weiter insbesondere eine Lichtmaschine eines Kraftfahrzeugs, umfassend
mindestens eine Überspannungsschutzvorrichtung (57) nach Anspruch 13 für eine elektrische Maschine (46), die innerhalb der Kraftfahrzeugkomponente angeordnet und elektrisch damit in Kontakt gebracht wird, oder
mindestens eine Diodenträgeranordnung (1) nach den Ansprüchen 1 bis 12, die innerhalb der Kraftfahrzeugkomponente, insbesondere einer elektrischen Maschine (46), angeordnet ist,
wobei die Diodenträgeranordnung (1) mit einer Schutzabdeckung (48) der Kraftfahrzeugkomponente zusammengesetzt ist, um eine Unteranordnung zu bilden,
wobei die Diodenträgeranordnung (1) gegen die Schutzabdeckung (48) gepresst und durch Klemmen, beispielsweise durch Befestigungsvorsprünge (39) der Diodenträgeranordnung (1), an der Schutzabdeckung (48) fixiert wird,
wobei die Schutzabdeckung (48) weiter einen Verbinder (49a) eines Abdeckungsleistungszuführungsleiters, der konfiguriert ist, um als Leistungszuführung zur Diodenträgeranordnung (1) zu dienen, und einen Verbinder (50a) einer Abdeckungsneutralleiters umfasst, der konfiguriert ist, um als Masseversorgung zur Diodenträgeranordnung (1) zu dienen,
wobei die Unteranordnung durch Befestigungsmittel, vorzugsweise Befestigungsschrauben, an einem Hauptkörper (47) des Kraftfahrzeugbauteils angebracht wird,
wobei die Befestigungsmittel, vorzugsweise die Befestigungsschrauben, durch die Befestigungsvorsprünge (39) der Diodenträgeranordnung (1) und die Befestigungsvorsprünge (39a) der Schutzabdeckung (48) verlaufen.

15. Verfahren zur Herstellung einer Diodenträgeranordnung (1) nach den vorstehenden Ansprüchen mit den Schritten:
1) Bereitstellen eines ausgestanzten Rohling (72), umfassend eine erste Metallschiene (4), eine zweite Metallschiene (18) und zwischen der ersten Metallschiene (4) und der zweiten Metallschiene (18) mindestens einer Metallplatte (32), wobei die mindestens eine Metallplatte (32) durch Ausstanzen mittels Montagehilfsrippen (74) integral mit der ersten Metallschiene (4) verbunden ist und integral mit der zweiten Metallschiene (18) aus einem metallischen Plattenmaterial verbunden ist, und
2) Anpassen der Metallschienen (4, 18) an eine vorbestimmte Kontur einer elektrischen Maschine (46) durch Verformen oder Biegen, und
3) Bereitstellen eines Gehäuses (38) zum Halten der Metallschienen (4, 18) und der mindestens einen Metallplatte (32) aus einem thermoplastischen Material, beispielsweise aus einem spritzgießfähigen Polyamid 66 (PA66), aus Polybutylenterephthalat (PBT), Polyethylenterephthalat (PET) oder aus einem ähnlichen spritzgießfähigen Kunststoffmaterial, und/oder einem Füllmaterial, insbesondere einem Glas- oder Mineralfaserfüllmaterial, und Bereitstellen mindestens einer ersten Diodenaufnahme (44) zur Aufnahme einer Diode (2) und mindestens einer zweiten Diodenaufnahme (45) zur Aufnahme einer Diode (2), dadurch dass der bereitgestellte ausgestanzte Rohling (72), der die mindestens eine erste Diodenaufnahme (44) und die mindestens eine zweite Diodenaufnahme (45) bildet oder begrenzt, umspritzt wird, und
4) Abtrennen oder Abschneiden der Montagehilfsrippen (74) durch Stanzen, und
5) Einsetzen einer ersten Diode (2a) in die mindestens eine erste Diodenaufnahme (44), sodass diese erste Diode (2a) mittels des Gehäuses (38) an die erste Metallschiene (4) geklemmt wird, sodass sie elektrisch und thermisch leitend mit der ersten Metallschiene (4) in Kontakt steht, und elektrisch leitend integrales Verbinden des mindestens einen Verbindungskontaktstifts (58) dieser ersten Diode (2a) mit der mindestens einen Metallplatte (32), und
6) Einsetzen einer zweiten Diode (2b) in die mindestens eine zweite Diodenaufnahme (45), sodass diese zweite Diode (2b) mittels des Gehäuses (38) an die mindestens eine Metallplatte (32) geklemmt wird, sodass sie elektrisch und thermisch leitend mit der mindestens einen Metallplatte (32) in Kontakt steht, und elektrisch leitend, integrales Verbinden des mindestens einen Verbindungskontaktstifts (59) dieser zweiten Diode (2b) mit einer zweiten Metallschiene (18) dieser beiden Metallschienen (4, 18).

## Revendications

1. Agencement de porte-diode (1) pour un dispositif de protection contre les surtensions pour une machine électrique (46),
- l'agencement porte-diode (1) étant apte à être intégré dans la machine électrique (46),
- l'agencement porte-diode (1) comprenant :
- au moins deux diodes (2a, 2b), chacune étant équipée d'un corps de diode (60, 61) et d'au moins une broche de contact de connexion électrique (58, 59) disposée sur celui-ci pour entrer en contact électrique avec une diode respective (2a, 2b) et un contact de connexion électrique (63, 64) formé par le corps de diode (60, 61) ou formé d'un seul tenant avec le corps de diode (60, 61) pour entrer en contact électrique avec une diode respective (2a, 2b),
- un agencement de rails (3) comprenant deux rails métalliques électriquement conducteurs distincts (4, 18),
- au moins une plaque métallique électriquement conductrice distincte (32), dans lequel
- l'agencement porte-diode (1) comprend en outre un boîtier (38) disposé sur l'agencement de rail (3) et l'au moins une plaque métallique (32) pour maintenir l'agencement de rail (3) et l'au moins une plaque métallique (32),
- dans lequel l'enceinte (38) maintient l'au moins une plaque métallique (32) en sandwich entre les rails métalliques (4, 18) de sorte que l'au moins une plaque métallique (32) ne touche pas directement les rails métalliques (4, 18) et soit adjacente aux rails métalliques (4, 18),
- dans lequel l'agencement porte-diode (1) comprend au moins un premier réceptacle de diode (44) délimité ou formé par l'intermédiaire du boîtier (38) et d'un premier rail métallique (4) des deux rails métalliques (4, 18) destiné à recevoir une diode (2a, 2b), et au moins un deuxième réceptacle de diode (45) délimité ou formé par l'intermédiaire du boîtier (38) et de l'au moins une plaque métallique (32) destiné à recevoir une diode (2a, 2b),
- dans lequel une première diode (2a) est insérée dans l'au moins un premier réceptacle de diode (44) et est connectée d'un seul tenant, par sa ou ses broches de contact (58), à l'au moins une plaque métallique (32) de manière électriquement conductrice et, par l'intermédiaire du boîtier (38), est fixée sur le premier rail métallique (4) de sorte que son contact de connexion (63) soit en contact avec le premier rail métallique (4) de manière électriquement et thermiquement conductrice,
- dans lequel une deuxième diode (2b) est insérée dans l'au moins un deuxième réceptacle de diode (45), avec sa au moins une broche de contact (59) reliée de manière conductrice à un deuxième rail métallique (18) parmi les deux rails métalliques (4, 18) et fixées par l'intermédiaire du boîtier (38) sur l'au moins une plaque métallique (32) de sorte que son contact (64) et/ou son corps de diode (61) soit électriquement mis en contact avec l'au moins une plaque métallique (32) de manière thermiquement conductrice.

2. Agencement porte-diode (1) selon la revendication 1,
**caractérisé en ce que**
- l'au moins un premier réceptacle de diode (44) et l'au moins un deuxième réceptacle de diode (45) sont agencés de part et d'autre (65, 66) de l'agencement porte-diode (1) qui sont opposés l'un à l'autre, ou
- au moins un premier réceptacle de diode (44) et au moins un deuxième réceptacle de diode (45) sont agencés du même côté (65, 66) de deux côtés (65, 66) de l'agencement porte-diode (1) qui sont opposés l'un à l'autre.

3. Agencement porte-diode (1) selon la revendication 1 ou 2,
**caractérisé en ce que**
l'au moins un premier réceptacle de diode (44) et l'au moins un deuxième réceptacle à diode (45) sont de taille identique.

4. Agencement porte-diode (1) selon l'une quelconque des revendications précédentes,
**caractérisé en ce que**
- l'au moins un premier réceptacle de diode (44) est disposé dans un premier plan (67) ou au moins deux premiers réceptacles de diode (44) définissent un premier plan (67), et/ou
- l'au moins un deuxième réceptacle de diode (45) est disposé dans un deuxième plan (68) ou au moins deux deuxièmes réceptacles de diode (45) définissent un deuxième plan (68), et/ou
- le premier plan (67) et le deuxième plan (68) sont parallèles entre eux et/ou décalés l'un par rapport à l'autre.

5. Agencement porte-diode (1) selon l'une quelconque des revendications précédentes,
**caractérisé en ce que**
- le premier rail métallique (4) et/ou le deuxième rail métallique (18) et/ou l'au moins une plaque métallique (32) sont chacun réalisés d'un seul tenant et/ou avec un corps plat chacun, et/ou
- la première diode (2a) disposée dans l'au moins un premier réceptacle de diode (44) est électriquement connectée en série avec la deuxième diode (2b) disposée dans l'au moins un deuxième réceptacle de diode (45), et/ou
- la première diode (2a) disposée dans l'au moins un premier réceptacle de diode (44) est électriquement connectée en série avec la deuxième diode (2b) disposée dans l'au moins un deuxième réceptacle de diode (45) et par rapport à au moins une autre première diode (2a) et au moins une autre deuxième diode (2b), qui sont disposées dans un autre premier réceptacle de diode (44) ou un autre deuxième réceptacle de diode (45) et sont électriquement connectées en série entre elles, sont électriquement connectées en parallèle.

6. Agencement porte-diode (1) selon l'une quelconque des revendications précédentes,
**caractérisé en ce que**
le boîtier (38) est formé par un composant contigu d'une seule pièce ou par des segments séparés.

7. Agencement porte-diode (1) selon l'une quelconque des revendications précédentes,
**caractérisé en ce que**
- le premier rail métallique (4) dans son extension principale définit un axe principal (62) et est divisé en trois portions de rail plates contiguës (5, 10, 14) s'étendant dans la direction de l'axe principal (62),
- dans lequel le premier rail métallique (4) comprend deux parties de flexion intégrales (9, 13), qui, par rapport à l'axe principal (62), sont chacune disposées entre deux parties de rail (5, 10, 14) et les relient d'un seul tenant entre elles,
- dans lequel les parties de flexion (9, 13) sont déformées ou pliées transversalement à l'axe principal (62) de sorte que les parties de rail (5, 10, 14) soient inclinées l'une vers l'autre selon un angle de flexion prédéterminé ou prédéterminable (69), et/ou
- dans lequel l'angle de flexion (69) atteint au maximum 45° et/ou
- dans lequel l'angle de flexion (69) est au minimum de 5° ou inférieur à 5°,
- dans lequel la largeur (70) des parties de flexion (9, 13) qui sont orientées transversalement par rapport à l'axe principal (62) est inférieure à la largeur (71) des parties de rail (5, 10, 14) également orientées transversalement par rapport à l'axe principal (62), ou
- dans lequel une largeur (70) des parties de flexion (9, 13) qui sont orientées transversalement par rapport à l'axe principal (62) représente au maximum 50 % ou particulièrement moins de 25 % ou plus particulièrement moins de 10 % d'une largeur (71) des parties de rail (5, 10, 14) également orientées transversalement par rapport à l'axe principal (62), et/ou
- dans lequel une largeur (70) des parties de flexion (9, 13), qui sont orientées transversalement par rapport à l'axe principal (62), représente au moins 25 % d'une largeur (71) des parties de rail (5, 10, 14) également orientées transversalement par rapport à l'axe principal (62).

8. Agencement porte-diode (1) selon la revendication 7,
**caractérisé en ce que**
- l'au moins un premier réceptacle de diode (44) est délimité ou formé par une portion de rail plat (5, 10, 14) du premier rail métallique (4) et par un premier élément de support transversal (42) du boîtier (38), et/ou
- dans lequel le premier élément de support transversal (42) fixe élastiquement la première diode (2a) insérée dans l'au moins un premier réceptacle de diode (44) sur la portion de rail respective (5, 10, 14) du premier rail métallique (4), et/ou
- l'au moins un deuxième réceptacle de diode (45) est délimité ou formé par l'au moins une plaque métallique (32) et par un deuxième élément de support transversal (43) du boîtier (38), et/ou
- dans lequel le deuxième élément de support transversal (43) fixe élastiquement la deuxième diode (2b) insérée dans l'au moins un deuxième réceptacle de diode (45) sur l'au moins une plaque métallique (32).

9. Agencement porte-diode (1) selon l'une quelconque des revendications précédentes,
**caractérisé en ce que**
- l'agencement de rail (3) comprend notamment une languette de contact de connexion décalée (17) disposée sur le premier rail métallique (4) de ces deux rails métalliques (4, 18), qui est équipée pour le brasage ou le soudage, notamment par soudage par résistance, d'un conducteur d'alimentation électrique (49) d'une machine électrique (46), et/ou
- l'agencement de rail (3) comprend en outre une languette de contact de connexion décalée (30) disposée sur le deuxième rail métallique (18) de ces deux rails métalliques (4, 18) qui est équipée pour le brasage ou le soudage, notamment par soudage par résistance, d'un conducteur neutre (50) d'une machine électrique (46),
- la languette de contact de connexion (17) et la languette de contact de connexion supplémentaire (30) sont disposées de deux côtés de l'agencement porte-diode (1) qui sont opposés l'un à l'autre.

10. Agencement porte-diode (1) selon l'une quelconque des revendications précédentes,
**caractérisé en ce que**
- le boîtier (38) comprend des projections de fixation (39) pour fixer l'agencement porte-diode (1) à une machine électrique (46), en particulier un générateur, et plus particulièrement un alternateur de véhicule à moteur, et/ou
- dans lequel les saillies de fixation (39) sont chacune équipées d'une ouverture centrale (40) pour les moyens de fixation, notamment une vis de fixation.

11. Agencement porte-diode (1) selon l'une quelconque des revendications précédentes,
**caractérisé en ce que**
- le boîtier (38) est fabriqué à partir d'un matériau thermoplastique, par exemple à partir de polyamide 66 (PA66) moulable par injection, de polybutylène téréphtalate (PBT), de polyéthylène téréphtalate (PET) ou d'un matériau plastique moulable par injection similaire et/ou
- le boîtier (38) est produit à partir d'un matériau thermoplastique, par exemple à partir d'un polyamide 66 (PA66) moulable par injection, de polybutylène téréphtalate (PBT), de polyéthylène téréphtalate (PET) ou d'un matériau plastique moulable par injection similaire, et d'un matériau de remplissage, en particulier un matériau de remplissage en fibre de verre ou minérale.

12. Agencement porte-diode (1) selon l'une quelconque des revendications précédentes,
**caractérisé en ce que**
- le premier rail métallique (4) et/ou le deuxième rail métallique (18) sont réalisés au moyen de pièces poinçonnées et/ou sont découpés dans une fine feuille de métal conducteur et/ou
- le premier rail métallique (4) et/ou le deuxième rail métallique (18) sont réalisés en cuivre, en laiton, en bronze ou en d'autres matériaux métalliques conducteurs, et/ou
- l'au moins une plaque métallique (32) est réalisée par une partie poinçonnée et/ou découpée dans une fine feuille de métal conducteur et/ou
- l'au moins une plaque métallique (32) est réalisée en cuivre, en laiton, en bronze ou en d'autres matériaux métalliques conducteurs.

13. Dispositif de protection contre les surtensions (57) pour une machine électrique (46), notamment un générateur, et plus particulièrement un alternateur de véhicule à moteur, comprenant au moins un agencement porte-diode (1) selon les revendications 1 à 12 précédentes,
- dans lequel les diodes (2a, 2b) de l'agencement porte-diodes (1) sont configurées pour protéger la machine électrique (46) d'une tension d'alimentation également appelée surtension, qui, en raison d'un défaut, dépasse la tension nominale de la machine électrique (46).

14. Composant de véhicule automobile, notamment une machine électrique (46), notamment un générateur, et plus particulièrement un alternateur de véhicule automobile, comprenant
au moins un dispositif de protection contre les surtensions (57) selon la revendication 13 pour une machine électrique (46) agencée à l'intérieur du composant du véhicule automobile et en contact électrique avec celui-ci, ou
au moins un agencement porte-diode (1) selon les revendications 1 à 12 agencé dans le composant du véhicule automobile, en particulier une machine électrique (46),
dans lequel l'agencement porte-diode (1) est assemblé avec un couvercle de protection (48) du composant du véhicule automobile pour former un sous-ensemble,
dans lequel l'agencement porte-diode (1) est pressé contre le couvercle de protection (48) et fixé au couvercle de protection (48) par serrage, par exemple en fixant les projections (39) de l'agencement porte-diode (1),
dans lequel le couvercle de protection (48) comprend en outre un connecteur de conducteur d'alimentation du couvercle (49a) configuré pour servir d'alimentation électrique pour l'agencement porte-diode (1) et un connecteur de conducteur neutre du couvercle (50a) configuré pour servir d'alimentation de terre pour l'agencement porte-diode (1),
dans lequel ledit sous-ensemble est assemblé à un corps principal (47) du composant du véhicule automobile par des moyens de fixation, de préférence des vis de fixation,
dans lequel les moyens de fixation, de préférence les vis de fixation, passent par les projections de fixation (39) de l'agencement porte-diode (1) et les projections de fixation (39a) du couvercle de protection (48).

15. Procédé de fabrication d'un agencement porte-diode (1) selon les revendications précédentes, comportant les étapes suivantes :
1) la fourniture d'une ébauche perforée (72) comprenant un premier rail métallique (4), un deuxième rail métallique (18) et entre le premier rail métallique (4) et le deuxième rail métallique (18) au moins une plaque métallique (32), dans lequel l'au moins une plaque métallique (32) est reliée d'un seul tenant au premier rail métallique (4) par des nervures d'aide à l'installation (74) et reliée d'un seul tenant au deuxième rail métallique (18), en matériau de plaque métallique par poinçonnage, et
2) l'adaptation des rails métalliques (4, 18) à un contour prédéterminé d'une machine électrique (46) par déformation ou pliage, et
3) la fourniture d'un boîtier (38) destiné à contenir les rails métalliques (4, 18) et l'au moins une plaque métallique (32) en matériau thermoplastique, par exemple en polyamide 66 (PA66) moulable par injection, en polybutylène téréphtalate (PBT), en polyéthylène téréphtalate (PET) ou en un matériau plastique moulable par injection similaire, et/ou un matériau de remplissage, notamment un matériau de remplissage en fibre de verre ou minérale, et la fourniture d'au moins un premier réceptacle de diode (44) destiné à recevoir une diode (2) et d'au moins un deuxième réceptacle de diode (45) destiné à recevoir une diode (2), en ce que l'ébauche perforée fournie (72), formant ou délimitant l'au moins un premier réceptacle de diode (44) et l'au moins un deuxième réceptacle de diode (45), est surmoulée, et
4) le sectionnement ou la coupe des nervures d'aide à l'installation (74) par poinçonnage, et
5) l'insertion d'une première diode (2a) dans l'au moins un réceptacle de première diode (44), de sorte que cette première diode (2a) soit fixée sur le premier rail métallique (4) par l'intermédiaire du boîtier (38), de sorte qu'elle soit en contact électrique et thermique avec le premier rail métallique (4), et la connexion intégrale électriquement conductrice de l'au moins une broche de contact (58) de cette première diode (2a) avec l'au moins une plaque métallique (32), et
6) l'insertion d'une deuxième diode (2b) dans l'au moins un deuxième réceptacle de diode (45), de sorte que cette deuxième diode (2b) soit fixée par l'intermédiaire du boîtier (38) sur l'au moins une plaque métallique (32) de sorte qu'elle soit en contact électrique et thermique avec l'au moins une plaque métallique (32), et la connexion intégrale électriquement conductrice de l'au moins une broche de contact de connexion (59) de cette deuxième diode (2b) avec un deuxième rail métallique (18) de ces deux rails métalliques (4, 18).
